# EUROPEAN PATENT APPLICATION

(11) **EP 4 592 014 A1**
(43) Date of publication of application: **30.07.2025**
(21) Application number: 24829989.3
(22) Date of filing: 20.03.2024
(51) Int. Cl.: B23K 20/12

(54) **SOLID-STATE MACHINING METHOD AND SOLID-STATE MACHINING DEVICE**

(30) Priority: 27.06.2023 CN 202310765380
(71) Applicant: IDQ Science and Technology (Guangdong, Hengqin) Co., Ltd, Zhuhai, Guangdong 519031 (CN); Institute for the Development and Quality, Macau, Macau 999078 (CN); Aerospace Engineering Equipment (Suzhou) Co., Ltd., Suzhou, Jiangsu 215100 (CN)
(72) Inventor: GUO, Dawei, Macau, Avenida Padre Tomás Pereira, SN, Taipa, Macao 999078 (CN); QIAO, Qian, Zhuhai, Guangdong 519031 (CN); WANG, Hu, Suzhou, Jiangsu 215100 (CN); LAM, Waii, Macau, Avenida Padre Tomás Pereira, SN, Taipa, Macao 999078 (CN); ZHOU, Min, Zhuhai, Guangdong 519031 (CN); LI, Wenxiao, Suzhou, Jiangsu 215100 (CN); ZHU, Zhixiong, Suzhou, Jiangsu 215100 (CN); YANG, Guoshun, Suzhou, Jiangsu 215100 (CN); KWOK, Chitat, Macau, Avenida Padre Tomás Pereira, SN, Taipa, Macao 999078 (CN); TAM, Lapmou, Macau, Avenida Padre Tomás Pereira, SN, Taipa, Macao 999078 (CN)
(74) Representative: Patent 42
(86) International application number: PCT/CN2024/082799
(87) International publication number: WO 2025/001336

(57) **Abstract**

The present application involves a solid-state manufacturing method, which includes: connecting a solid-state manufacturing tool to a transition spindle for driving through a machine head; starting the solid-state manufacturing device and moving the solid-state manufacturing tool to process along a predetermined manufacturing route; during the solid-state manufacturing process, measuring deformation of a deformation detection region on the transition spindle by a strain gauge to monitor force and/or torque on the transition spindle; monitoring the temperature of the solid-state manufacturing tool by a first temperature monitoring assembly; and monitoring the temperature in the deformation detection region by a second temperature monitoring assembly.

## Description

### TECHNICAL FIELD

The present application relates to the field of solid-state manufacturing technology, in particular to a solid-state manufacturing method and a solid-state manufacturing device.

### BACKGROUND

At present, on the one hand, the force and torque of the stir tool during solid-state manufacturing process are often monitored by the force sensor and torque sensor positioned in the spindle. However, once the installation is completed, the range is limited, and it is complicated to repair or replace the sensor with a different range, the high cost of the sensors is also a concern. Additionally, the temperature at the location where force and torque are monitored can significantly impact the final monitoring results, and there is currently no effective means to monitor the temperature. On the other hand, previous temperature measurement of the tip of the tool during solid-state manufacturing process usually adopted the following three methods, which are not precise enough or costly. The first method involves using an infrared imaging instrument to detect the temperature of solid-state manufacturing tools and the manufacturing position. However, this method may not provide accurate measurements due to affection of the oxidation of the surface of the objects of different materials and the temperature of all objects on the radiation coefficient. The second method is to detect the temperature of the heat-affected region near the manufacturing position by the sliding contact thermocouple. However, actual working conditions, such as surface roughness of the workpiece, the adaptive space and the sliding speed, can limit the accuracy of temperature measurements obtained using the sliding contact thermocouple, resulting in inaccurate temperature measurements. The third method is to place a thermocouple wire near the solid-state manufacturing position through the pre-processed holes or grooves, when the solid-state manufacturing process is completed, the thermocouple tip will form a metallurgical bond with materials nearby, causing it unusable for subsequent measurements, as a result, this method is costly.

### SUMMARY

The present application provides a solid-state manufacturing method and a solid-state manufacturing device to solve a problem in the related art.

The technical problem solved by the present application is implemented using the following technical solutions:
In a first aspect, the present application provides a solid-state manufacturing method.
connecting a solid-state manufacturing tool to a transition spindle for driving through a machine head;
starting the solid-state manufacturing device and moving the solid-state manufacturing tool to process along a predetermined route;
during solid-state manufacturing process, measuring deformation of a deformation detection region on the transition spindle by a strain gauge to monitor force and/or torque on the transition spindle;
monitoring the temperature of the solid-state manufacturing tool by a first temperature monitoring assembly; And
monitoring the temperature in the deformation detection region by a second temperature monitoring assembly.

In a second aspect, the present application provides a solid-state manufacturing device, wherein the solid-state manufacturing device implements the method as mentioned above.

The present application has the beneficial effect of:
During solid-state manufacturing process, the deformation of the deformation detection region on the transition spindle is measured by strain gauges to monitor the force and/or torque of the transition spindle; The strain gauges are characterized by small size, lightweight, simple structure, fast measurement speed, and basically have no impact on the working state of the measured part and the distribution of the stress during measurement, which makes them suitable for dynamic measurements. The temperature of the solid-state manufacturing tool is monitored by a first temperature monitoring assembly to obtain the real-time working temperature of the solid-state manufacturing tool, which facilitates the adjustment of the working parameters of the solid-state manufacturing tool based on the obtained temperature information. The second temperature monitoring assembly monitors the temperature in the deformation detection region, which provides real-time insights of the temperature of the deformation detection region, which facilitates the user to carry out targeted adjustments based on the obtained temperature information, and prevents the temperature of the deformation detection region from being too high or low, which affects the accuracy of the measurement.

### BRIEF DESCRIPTION OF THE DRAWINGS

In order to more clearly illustrate the technical solutions in the embodiments or related art of the present application, the accompanying drawings to be used in the description of the embodiments or related art will be briefly introduced below, and it will be obvious that the accompanying drawings in the following description are only some of the embodiments of the present application, and that other drawings can be obtained according to these drawings by those skilled in the art without creative labor. The accompanying drawings.

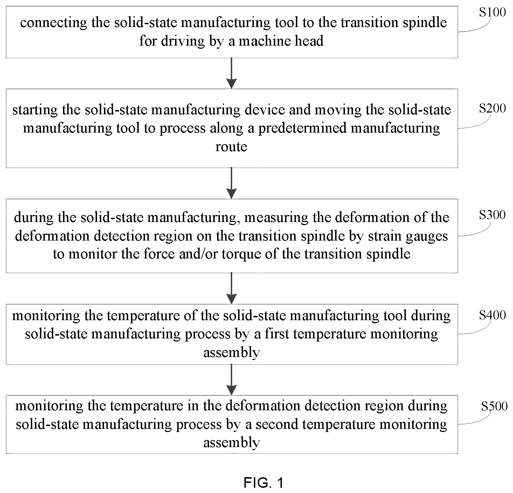

FIG. 1 is a flowchart of a solid-state manufacturing method of the present application.
FIG. 2 is a schematic diagram of an overall use of one embodiment of the present application.
FIG. 3 is a schematic diagram of solid-state manufacturing on a base material of the present application.

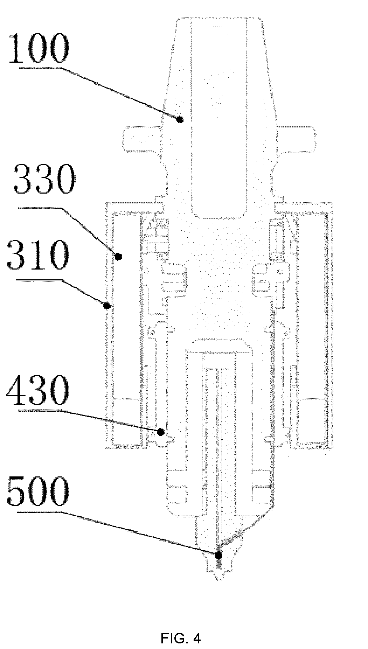

FIG. 4 is a schematic structural diagram of one embodiment of the wireless shaft handle of the present application.
FIG. 5 is a schematic structural diagram of another embodiment of the wireless shaft handle of the present application.
FIG. 6 is a schematic diagram of the main view structure of the present application.
FIG. 7 is a schematic diagram of an oblique view structure of the present application.
FIG. 8 is a schematic diagram of a top view structure of FIG. 6.
FIG. 9 is a schematic diagram of a sectional view structure made along line A-A in FIG. 8.
FIG. 10 is a schematic diagram of an enlarged structure at D of FIG. 9.
FIG. 11 is a schematic diagram of a section view structure made along line B-B in FIG. 8.
FIG. 12 is an embodiment of the present application with respect to a connection assembly.
FIG. 13 is a schematic diagram of an enlarged structure at E of FIG. 12.
FIG. 14 is an alternative embodiment of the present application with respect to a connection assembly.
FIG. 15 is an enlarged schematic structural diagram at F of FIG. 14.
FIG. 16 is a schematic diagram of a main view structure of a wireless smart shaft handle.
FIG. 17 is a schematic diagram of a sectional view structure made along the line C-C in FIG. 16.

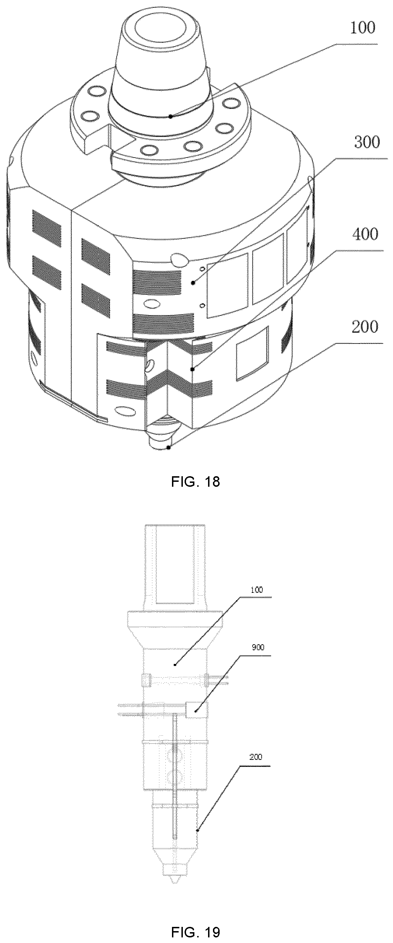

FIG. 18 is a schematic diagram of an oblique view structure of the wireless smart shaft handle.
FIG. 19 is a schematic diagram of a connection structure between the transition spindle and the strain measurement assembly.
FIG. 20 is a schematic diagram of a sectioned structure of the transition spindle.
FIG. 21 is a schematic diagram of a structure about a cooling section on the transition spindle.

Reference numbers:
100, transition spindle; 200, manufacturing section; 300, control device; 400, cooling device;
500, first temperature monitoring assembly; 510, second temperature monitoring assembly; 600, positioning member; 700, heating module; 800, connection assembly; 900, strain measurement assembly; 1000, connection frame;
110, support region; 120, deformation detection region; 130, mounting hole; 140, threaded hole; 150, heat dissipation groove;
210, cavity channel; 211, inclined section; 212, vertical section; 212a, recess; 220, threaded construction;
310, protection sleeve; 320, integrated circuit board assembly; 321, wireless transceiver module; 322, temperature control panel; 330, power supply assembly;
410, cooling sleeve; 420, cooling cavity; 430, self-cooling assembly; 440, cold air gun;
810, magnetic suction member; 820, fixing clasp; 830, first threaded hole;
a, base material; b, weld seam.

### DETAILED DESCRIPTION OF THE EMBODIMENTS

In order to make the technical means, the creative features, and the purpose and efficacy achieved by the present application easy to understand and understand, the present application is further elaborated in the following, considering the specific drawings.

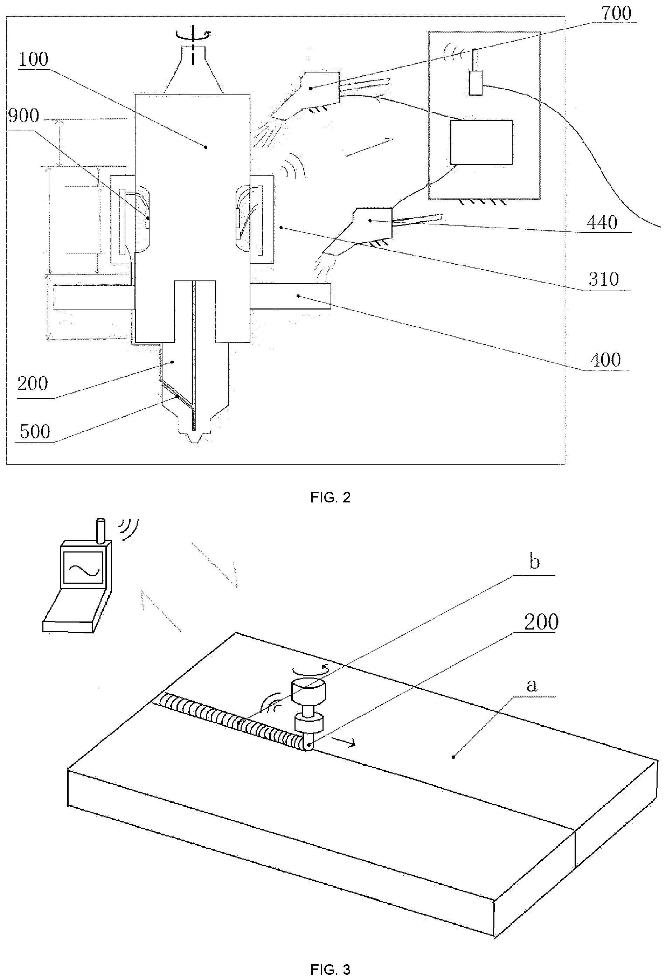

In order to solve the above technical problems, please refer to the accompanying drawings for understanding, the first aspect of the present application proposes a solid-state manufacturing method, the steps of which include:
S100: Connecting the solid-state manufacturing tool to the transition spindle 100 for driving by a machine head; Installing the solid-state manufacturing tool on one side of the transition spindle 100, and driving the transition spindle 100 by the machine head so as to drive the solid-state manufacturing tool to perform rotational work;
S200: Starting the solid-state manufacturing device and moving the solid-state manufacturing tool to process along a predetermined manufacturing route as shown in FIG. 3; Starting the solid-state manufacturing device to drive the machine head, the transition spindle 100, and the solid-state manufacturing tool, enable to perform mobile solid-state manufacturing along the solid-state manufacturing route on the base material a;
S300: During the solid-state manufacturing process, measuring the deformation of the deformation detection region 120 on the transition spindle 100 by strain gauges to monitor the force and/or torque of the transition spindle 100; Multiple sets of strain gauges are attached to the outside of the transition spindle 100, at least one set of strain gauges is used to measure the downward force of the transition spindle 100, and at least one set of strain gauges is used to measure the torque of the transition spindle 100;
S400: Monitoring the temperature of the solid-state manufacturing tool during solid-state manufacturing process by a first temperature monitoring assembly 500; Monitoring the temperature of the solid-state manufacturing tool in real time by the first temperature monitoring assembly 500, obtaining real-time parameters so as to facilitate feedback adjustment by the user;
S500: Monitoring the temperature on the deformation detection region 120 during solid-state manufacturing process by a second temperature monitoring assembly 510; Setting the second temperature monitoring assembly 510 at the deformation detection region 120 of the transition spindle 100, monitoring the temperature of the deformation detection region 120 in real time by the second temperature monitoring assembly 510, which can also be the temperature of the strain gauges, preventing the strain gauges from being in a higher or lower temperature region and the user from being unaware of this, which may lead to inaccurate results over time and lack of user awareness.

The solid-state manufacturing method can be a friction stir welding method or a solid-state additive manufacturing method, when the solid-state manufacturing method is a friction stir welding method, the solid-state manufacturing tool is a friction stir welding tool; When the solid-state manufacturing method is a solid-state additive manufacturing method, the solid-state manufacturing tool is a hollow stir tool.

There is a control device 300 on the outside of the transition spindle 100 and during the solid-state manufacturing, the control device 300 sends and receives wireless signals from the strain gauge, the first temperature monitoring assembly 500, and the second temperature monitoring assembly 510; The control device 300 converts the wireless signals into numerical values displayed on a terminal, so as to facilitate the user to intuitively understand a variety of manufacturing parameter information. During solid-state manufacturing process, the integrated circuit board assembly 320 within the control device 300 transmits and receives the wireless signals of the strain gauge, the first temperature monitoring assembly 500, and the second temperature monitoring assembly 510, and the corresponding signals are displayed on the terminal, and the power supply assembly 330 within the control device 300 supplies power to the integrated circuit board assembly 320; The strain gauge, the first temperature monitoring assembly 500, and the second temperature monitoring assembly 510 can all be connected to the integrated circuit board assembly 320, and since the control device 300 moves with the strain gauge, the first temperature monitoring assembly 500, and the second temperature monitoring assembly 510, the transmission of the signals will be more stable and the final monitored data will be more accurate. Based on the detected spindle torque, force, and the temperature of the stir tool, it will determine whether the solid-state manufacturing process or manufacturing parameters are appropriate, and then provide feedback to the control device 300, which responds by adjusting the parameters in real-time.

S110: Before the solid-state manufacturing process begins, a strain gauge is adhered to the deformation detection region 120 on the transition spindle 100, and the mechanical data to be measured by the strain gauge, such as force, torque, etc., are calibrated in advance.

S111: A method of calibrating the force is placing the transition spindle 100 on a designated mold with the bottom of the transition spindle 100 fixed, and applying sequentially increasing force of known magnitude from the top of the transition spindle 100. The control device 300 receives the force signal and calibrates the displayed force signal accordingly.

S112: A method of calibrating the torque is placing the transition spindle 100 on a designated mold with the bottom of the transition spindle 100 fixed and applying sequentially increasing torque of known magnitude from the top of the transition spindle 100. The control device 300 receives the torque signal and calibrates the displayed torque signal accordingly.

S113: Before the start of the solid-state manufacturing process, a first temperature monitoring assembly 500 is inserted into an end of the cavity channel 210 inside the solid-state manufacturing tool near its end to enable real-time monitoring of the temperature during the solid-state manufacturing process via the monitoring end of the first temperature monitoring assembly 500, minimizing heat lost during conduction, which could lead to inaccurate temperature information.

Specifically, monitoring the temperature of the manufacturing end of the solid-state manufacturing tool by positioning a thermocouple at one of a vertical section 212 and an inclined section 211 of the cavity channel 210, and placing a positioning member 600 at the other of the vertical section 212 and the inclined section 211 of the cavity channel 210 to position the thermocouple, preventing phenomena such as shifting or collision of the thermocouple in the process of high-speed rotation.

During the solid-state manufacturing process, the transition spindle 100 has a cooling device 400 on the outside of the transition spindle 100, and the cooling device 400 faces the side of the solid-state manufacturing tool, and the heat transferred from the solid-state manufacturing tool to the transition spindle 100 is cooled by the cooling device 400 to avoid the temperature of the transition spindle 100 from becoming too high; As the transition spindle 100 is provided with a control device 300 and electrical assemblies, such as strain gauges, an excessively elevated temperature tends to cause these electrical assemblies to be out of calibration or fail, so it is necessary to dissipate the heat transferred from the solid-state manufacturing tool to the transition spindle 100; Heat insulation can also be accomplished using a heat-insulating assembly placed between the transition spindle 100 and the solid-state manufacturing tool; Both methods of cooling the transition spindle 100 may be utilized; Preferably, both cooling methods should be employed simultaneously, in practical applications, reliance on a single approach may yield erroneous measurements findings.

S311: There are various embodiments of the cooling device, one of which is that the cooling device 400 includes a cooling sleeve 410 rotationally connected to the outside of the transition spindle 100, the cooling sleeve 410 has a cooling module to cool the transition spindle 100. During the solid-state manufacturing process, the transition spindle 100 rotates with respect to the cooling sleeve 410, and the cooling sleeve 410 remains stationary, and this method of setting up the cooling device is more stable and reliable, as the cooling sleeve is fixedly connected to the frame, and does not rotate with the transition spindle 100, which can be referred as the "wired type".

S3111: The cooling module in the cooling sleeve 410 controls the cooling efficiency by adjusting the fluid temperature and flow rate into the cooling cavity 420 during the solid-state manufacturing process; For example, when a faster cooling rate is required, the fluid temperature can be decreased and the flow rate of the fluid is increased; When a slower cooling rate is needed, it takes the opposite measures.

S312: Another cooling device for the "wireless" cooling, that is, the cooling device 400 is fixed in the transition spindle 100 connected to the outside of the self-cooling assembly 430, during the solid-state manufacturing process, the self-cooling assembly 430 rotates synchronously with the transition spindle 100; This design results in a smaller overall structure, lighter weight, and more convenient use.

Of course, there may be other cooling methods that can be used, here just to cite a few implementable ways to facilitate understanding.

S3121: The self-cooling assembly 430 is a semiconductor cooler and/or a fan, and during the solid-state manufacturing process, the transition spindle 100 is cooled by the semiconductor cooler and/or the fan; The semiconductor cooler is small and lightweight and is suitable for rotating along with the transition spindle 100; The fan offers low cost and simple installation option, and whether it is a semiconductor or a fan in the installation, the semiconductor refrigeration sheet and/or the fan are evenly distributed on the outside of the transition spindle 100 to maintain weight balance at various places to prevent the transition spindle 100 from becoming unbalanced in high-speed rotation; In order to further improve the cooling effect, as shown in FIG. 2, it can be assisted by the cold wind gun 440 in order to achieve a more efficient refrigeration.

S510: When the second temperature monitoring assembly 510 monitors that the temperature at the deformation detection region 120 is below the minimum value of the preset temperature range, the heating module 700 can be controlled to heat the region; The preset temperature range can be selected according to the actual needs of the corresponding value, for example, 10°C-20°C, 20°C-30°C, 30°C-40°C, and so on; Of course, the preset temperature range can be selected according to specific needs. The interval can be set at 10°C as mentioned, or any other value, for example, 5°C or 6°C. The preset temperature range interval can be 10°C-15°C, 20°C-25°C, 10°C-16°C, 20°C-26°C and so on, the specific predetermined temperature range interval can be adjusted according to the change of the situation. Preferably, the preset temperature range fluctuates within the room temperature range.

S520: When the second temperature monitoring assembly 510 monitors that the temperature of the deformation detection region 120 is higher than the maximum value of the preset temperature range, the cooling efficiency of the cooling device 400 may be increased to reduce the heat transferred from the solid manufacturing tool to the transition spindle 100; The preset temperature range may be selected according to the actual need, such as 10°C-20°C, 20°C-30°C, 30°C-40°C and so on; Of course, the preset temperature range can be selected according to specific needs. The interval can be set at 10 °C as mentioned, or any other value, for example, 5 °C or 6°C. The preset temperature range interval can be 10°C -15°C, 20°C-25°C, 10°C-16°C, 20°C-26°C and so on, the specific predetermined temperature range interval can be adjusted according to the change of the situation. Preferably, the preset temperature range fluctuates within the room temperature range.

Through the combination of the two steps S510 and S520, since one end of two ends of the transition spindle 100 is the heating module 700, and the end close to the solid manufacturing tool is the cooling device 400, and the middle is the deformation detection region 120, which is also the position where the strain gauges are adhered; it is possible to dynamically control the temperature above and below the force measurement region. Since the force measurement region is synchronized to have the temperature read, so that no matter it is winter or summer, or the shank work heat, a constant temperature control is maintained according to the temperature value of the force measurement region and the upper and lower heating module 700 and cooling device 400, this ensure the test accuracy; it is also possible to use the second temperature monitoring assembly 510 to monitor the temperature of the deformation detection region 120, the temperature should be maintained at a fixed temperature (such as room temperature or the ambient temperature during calibration time), if it is found that the measured temperature of the transition region is found to be lower than this temperature, the heating module 700 operates, and if the measured temperature of the transition region is found to be higher than this temperature, the cooling device 400 operates to keep the temperature of the transition region from shifting significantly to ensure the accuracy of the measurement of the strain gauges.

Optionally, there are other ways of controlling the temperature, for example, without using the heating module 700, only changing the temperature of the fluid entering the cooling cavity 420, for example, the fluid entering the cooling cavity 420 has a higher temperature, and at this time the cooling cavity 420 plays a role of heating, replacing the heating module 700, and the temperature can also be controlled, and the description herein is only a description of the possible ways of realizing the purpose, and should not be regarded as a limitation on the present case.

Regarding the influence of the temperature at the deformation detection region 120 on the measurement of the strain gauge, it can also be canceled in other ways, for example, the deformation detection region 120 can be freely warmed up or cooled down, but before that it is calibrated at different temperatures, which can be selected according to the actual situation, and the temperature can be such as -30°C, -20°C, -10°C calibrated for lower temperatures, and so on, and also can be 0°C, 15°C, 20°C, 30°C, 40°C, 50°C, etc., and the temperature should be understood as the temperature range, such as -50°C -100°C, etc., to get the various temperatures under the law of the offset value of the strain measurement data, the error calibration curve corresponding to the temperature is input in the receiver inside, so that when testing, heating or cooling module can also not be used, the initial temperature is very low (winter) and after that, when the heat from the mixing head comes up to too high a temperature, the correct strain gauge values (force and torque) can be derived from the calibration curve based on the temperature and the signals received.

In order to achieve the intelligent control, the present application can also be used in conjunction with the use of the UI interface to read the input analog signals, read the PLC about the machine coordinates, XYZ running speed values, to achieve the PLC path control, motion control, such as automatic tool setting, determining the starting point and end point, setting the spindle rotation speed and Z downward force speed, XY moving speed, and to obtain the recording of data for the temperature, torque and force during solid-state manufacturing process, the monitoring and closed-loop adjustment; and to record solid-state manufacturing parameters (such as rotational speed, tool moving speed and zigzagging amount), monitoring data curves (temperature, torque and force) and videos during solid-state manufacturing process, and summarize them into the process database after entering the corresponding material types. Combined with Al artificial intelligence, when the curves during solid-state manufacturing process are abnormal, the software controls the PLC, to adjust the solid-state manufacturing parameters, and achieve the closed-loop control. Distributed control is carried out for the solid-state manufacturing process, i.e., at the initial stage, the identification and matching of temperature, force and torque are carried out to determine the material category, after which the process parameters are matched from the process database for solid-state manufacturing.

On the other hand, the present application also proposes a solid-state manufacturing device, the solid-state manufacturing device is for implementing the method described above.

The solid-state manufacturing device includes a smart shaft handle and a manufacturing portion 200 detachably connected to the smart shaft handle, the manufacturing portion 200 is a solid-state manufacturing tool; the smart shaft handle includes a transition spindle 100, a first end of the transition spindle 100 is connected to a drive spindle, and a second end of the transition spindle 100 is used for connecting to the manufacturing portion 200; the transition spindle 100 is mounted on the outside of the transition spindle 100 with a control device 300 and a cooling device 400. The cooling device 400 is located between the control device 300 and the manufacturing portion 200; a portion of the control device 300, the cooling device 400, and the monitoring device are support for installation by the transition spindle 100; and the cooling device 400 is provided between the manufacturing portion 200 and the control device 300, which is capable of effectively reducing the heat conducted from the manufacturing portion 200 to the control device 300, thereby providing protection for the control device 300. The smart shaft handle also includes a monitoring device, the monitoring device is connected to the control device 300, and the monitoring device is used to monitor the real-time parameters of the smart shaft handle and transmit the parameters to the control device 300 so as to adjust the solid-state manufacturing parameters by means of the obtained data, and to achieve the optimization of the indexes at the manufacturing position and the extension of the life of the solid-state manufacturing tool; the parameters may include, but are not limited to temperature, force, torque, spindle speed, solid-state manufacturing speed, downward force depth, and other data.

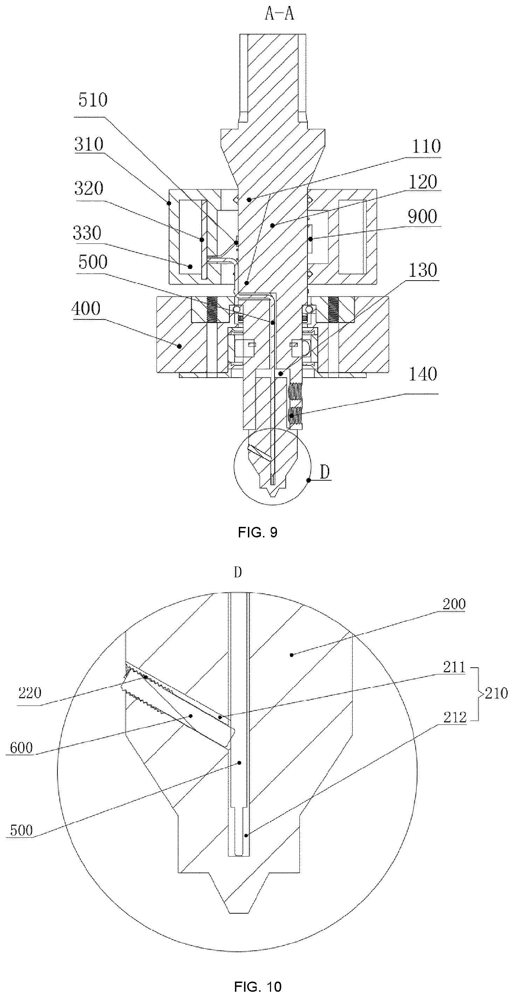

As shown in FIG. 9, the monitoring device includes a first temperature monitoring assembly 500 and a strain measurement assembly 900, the first temperature monitoring assembly 500 is used for monitoring the temperature of the manufacturing portion 200, and the strain measurement assembly 900 is used for measuring the downward force and/or torque of the spindle.

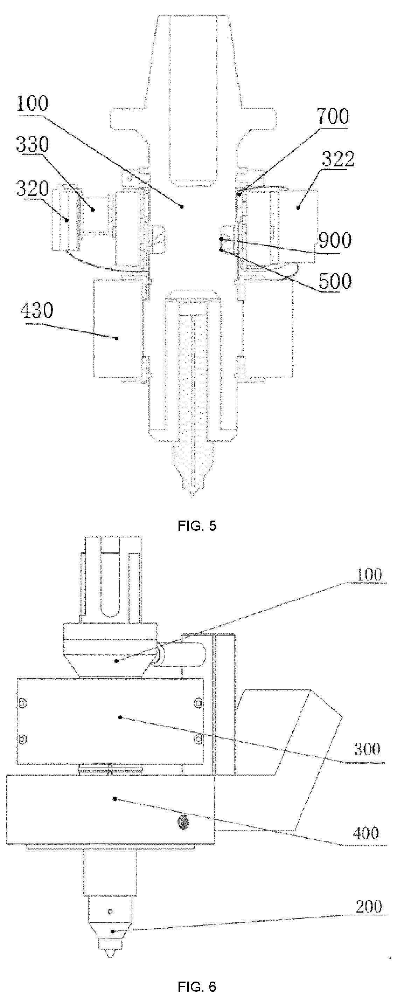

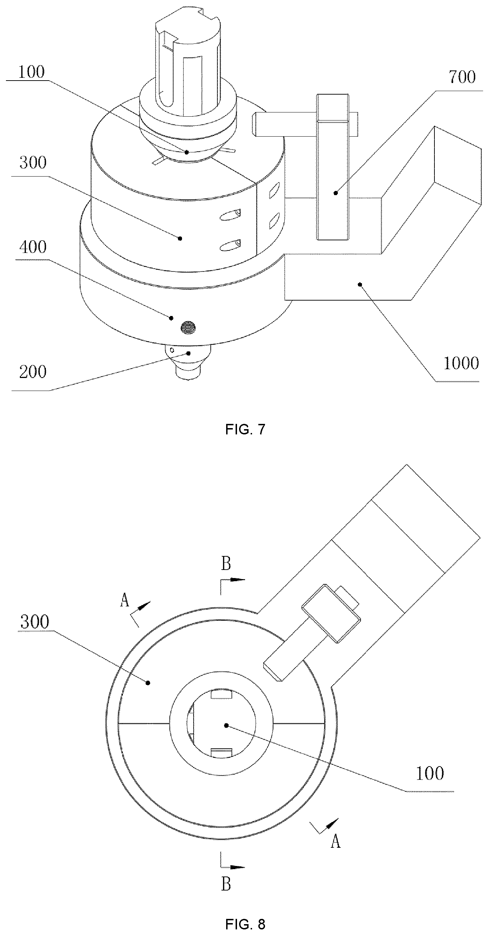

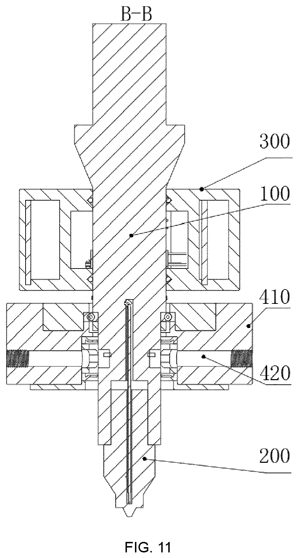

As shown in FIGS. 6-7 and FIG. 11, the cooling device 400 includes a cooling sleeve 410 rotationally connected to the outside of the transition spindle 100, and further, the rotational connection may be a bearing connection; the cooling sleeve 410 is fixedly connected to the frame via the connection bracket 1000, and a cooling module is provided inside the cooling sleeve 410. The cooling sleeve 410 can play the role of support bearing and protection for the cooling module inside; Optionally, the cooling module includes a cooling cavity 420 set inside the cooling sleeve 410, the cooling cavity 420 is opened with an inlet end and an outlet end, the cooling fluid enters the cooling cavity 420 from the inlet end and exits from the outlet end so as to take away the heat of the transition spindle 100, and the cooling fluid includes liquid cooling and air cooling. Liquid cooling can be chosen as conventional water cooling; air cooling can be compressed air, rare gases, carbon dioxide and other gases for forced convection. The above cooling sleeve 410 is fixedly connected to the frame through the connection frame 1000, the connection frame 1000 drives the cooling device 400 to follow the frame for multi-axis movement, the transition spindle 100 can drive the control device 300 and the monitoring device to rotate together. In order to facilitate understanding, to make a more detailed explanation is as follows: the embodiment in which the cooling device 400 is not rotated with the transition spindle 100.

Specifically, the rotation of the transition spindle 100 with respect to the cooling device 400 may be achieved in the following manner: First, the inner wall of the cooling sleeve 410 has a gap between the inner wall and the outer wall of the transition spindle 100 to form a cavity, and a skeleton oil seal is positioned at the top of the cavity to cooperate externally with the cavity, and internally with the spindle extension sleeve to seal off the top of the cavity, and a synthetic grease may be applied to facilitate the rotation of the spindle sleeve. After applying synthetic grease, it can achieve the rotation seal of the spindle sleeve. The lower part of the skeleton oil seal has a support ring, the outer diameter of which is matched with the inner diameter of the cavity, and another skeleton oil seal is placed under the support ring to close the lower part of the cavity. Finally, a tightening sleeve (ring) is installed at the bottom of the cooling sleeve 410, and the protruding position of the upper side of the tightening sleeve (ring) cooperates with the skeleton oil seal and is connected to the cooling sleeve 410 using four screws to provide axial tightening of the skeleton oil seal and the positioning ring, preventing the skeleton oil seal and the supporting ring from rotating along with the transition spindle 100. There are two threaded holes in the center position of the cooling sleeve 410 to connect the cooling cavity 420 for connecting a water pipe for supplying and discharging cooling water. The hollow section of the support ring should correspond to the cooling water inlet/outlet position. The above scenario is only one of several possible ways to achieve fluid cooling of the transition spindle 100, and is intended to facilitate the understanding of the technical solution, and should not be construed to play a limiting role.

There is another wireless use of the cooling device 400, i.e., the cooling device 400 includes a self-cooling assembly 430 fixedly attached to the outside of the transition spindle 100 and a fixing assembly, the self-cooling assembly 430 rotates with the transition spindle 100, the self-cooling assembly 430 can be a semiconductor refrigeration sheet and/or a fan, and the semiconductor refrigeration sheet and/or the fan is connected to the control device 300; Preferably, there can be multiple sets of the semiconductor refrigeration sheets or fans and are evenly distributed on the outside of the transition spindle 100, ensuring balanced weight distribution.

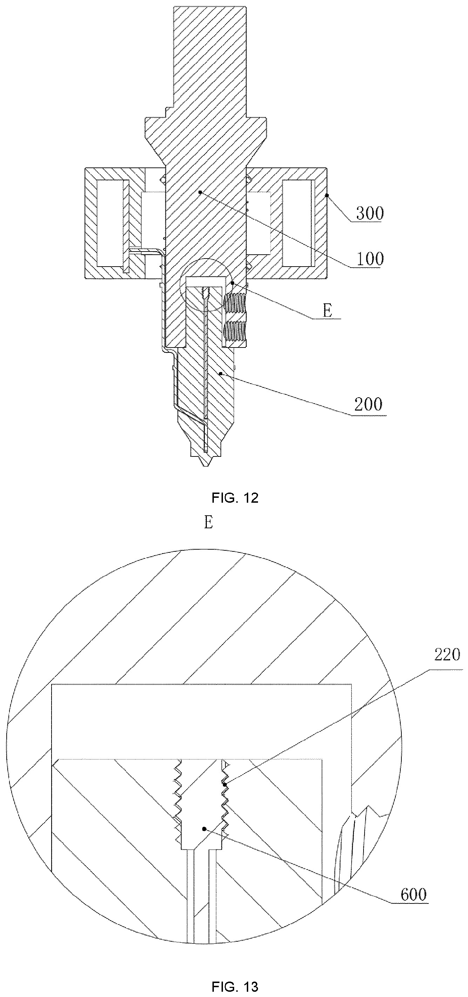

As shown in FIG. 2 and FIG. 12, the transition spindle 100 is also provided with a heating module 700 for heating the transition spindle 100 on the outside of the transition spindle 100, and the heating module 700 is connected to the control device 300, and the control device 300 may include a control panel, which allows regulation and control of the heating temperate. Optionally, as shown in FIG. 2, the heating module 700 may be a hot air gun, and the hot air gun can be mounted on the connection frame 1000 prevent it from rotating with the main body of the shank, and is used to jet a hot air stream to heat the shank and regulate the temperature of the measurement region when the smart shank is working in cold weather.

Optionally, the heating module 700 can also be a smaller and lighter heating element, such as a resistance heating piece, which can be used whether the cooling device 400 is stationary or rotates along with the transition spindle 100.

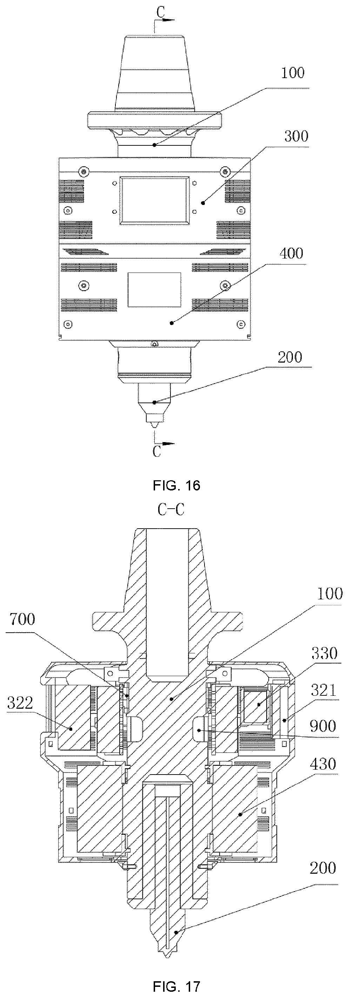

As shown in FIG. 17, the control device 300 includes an integrated circuit board assembly 320 and a power supply assembly 330, the integrated circuit board assembly 320 is connected to the power supply assembly 330, the integrated circuit board assembly 320 includes a wireless transceiver module 321 (the wireless transceiver module includes a wireless signal acquisition module and a wireless signal transmitting module) and a temperature control panel 322, and the wireless transceiver module 321 is connected to the monitoring device, the cooling device 400, and the heating module 700, and the temperature control panel 322 is connected to the monitoring device, the cooling device 400, and the heating module 700.

The connection relationship and the process of cooperatively using the first temperature monitoring assembly 500 are described in detail as follows. The cavity channel 210 is extended inside the manufacturing portion 200, the first end of the cavity channel 210 extends to the manufacturing end near the manufacturing portion 200 inside the manufacturing portion 200, and the first end of the cavity channel 210 is provided with a first temperature monitoring assembly 500 to real-time monitoring of the temperature near the manufacturing end of the manufacturing portion 200; the design minimizes heat loss during conduction, enabling the collection of more accurate temperature information for real-time monitoring of the temperature; Preferably, the first temperature monitoring assembly 500 can be a thermocouple, which offers with a broad measurement range, high measurement accuracy and are deformable, making it suitable in this application; Of course, other feasible temperature sensors such as RTDs that can fit into the cavity channel 210 can be selected according to the actual requirements.

As shown in FIG. 10, the cavity channel 210 includes an inclined section 211 and a vertical section 212 connected to the inclined section 211 inside the manufacturing portion 200, one of the inclined section 211 and the vertical section 212 is used for inserting the first temperature monitoring assembly 500, and the other of the inclined section 211 and the vertical section 212 is used for installing the positioning member 600 to locate the first temperature monitoring assembly 500 to prevent axial movement, and to avoid displacement and/or collision of the first temperature monitoring assembly 500 during high-speed rotation of the shaft handle and the manufacturing portion 200.

As shown in FIGS. 9-10 and 12-15, the positioning member 600 is a positioning rod, the first end of the positioning rod is used to position the first temperature monitoring assembly 500, and the second end of the positioning rod is fixed by the connection assembly 800. It can be understood that the positioning member 600 in the present application is not limited to the positioning rod of this embodiment, as long as it can be similar to the positioning rod to play the role of positioning or fixing the first temperature monitoring assembly 500, etc., for example, buckle clamping to fix and so on; the connection assembly 800 to fix positioning rod also has a variety of ways, and does not make special limitations, the following examples are listed for easy to understand technical solutions:

In one optional embodiment, as shown in FIGS. 9-10 and 12-13, the connection assembly 800 includes a threaded structure on one end of the positioning rod and the manufacturing portion 200, and the threaded structure on the positioning rod and the threaded structure on the manufacturing portion 200 can be connected in a threaded fit, and the threaded connection is cost-effective and easy to disassemble.

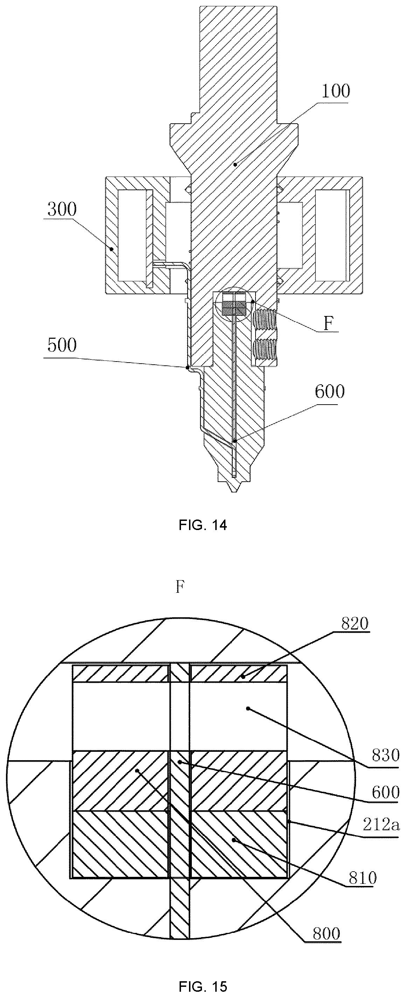

In another optional embodiment, as shown in FIGS. 14-15, the connection assembly 800 is a magnetic suction fixing assembly, the magnetic suction fixing assembly is adsorptive positioned on the side of the manufacturing portion 200 towards the transition spindle 100, the positioning member 600 passes through the magnetic suction fixing assembly in order to fix the positioning member 600 via the magnetic suction fixing assembly; a recess 212a is provided in the inlet end of the vertical section 212. The inlet end of the vertical section 212 is provided with a recess 212a, the inner wall of the recess 212a is adsorbed with a magnetic suction member 810, one side of the magnetic suction member 810 is adsorbed with a fixing clasp 820, the fixing clasp 820 and the magnetic suction member 810 are provided with through holes in the axial direction of the transition spindle 100, and the positioning rod (positioning member 600) is inserted into the vertical section 212 after passing through the through holes; there are various connections between the positioning rod and the magnetic suction fixing assembly, e.g., the positioning rod is of a magnetic metal, so that the positioning member 600 is fixed through the magnetic suction fixing assembly. For example, the positioning rod is a metal with magnetic properties, so that the positioning rod is adsorbed and connected to the magnetic suction member 810; a first threaded hole 830 can also be opened in the radial direction of the fixing clasp 820, so that the positioning rod is fixed to the magnetic suction fixing assembly by passing the screws through the first threaded holes 830.

Referring to FIG. 12, the first end of the thermocouple is connected to the control device 300 (as for the connection between the thermocouple and the control device 300, it may be that the thermocouple is directly connected to the control device 300; or it may be that the thermocouple is electrically connected to the control device 300 by wireless means); Specifically, the first end of the thermocouple is also connected to an integrated circuit board assembly 320 included in the control device 300, the integrated circuit board assembly 320 simultaneously transmits the temperature of the manufacturing portion 200 and the force, torque and other information of the spindle; the second end of the thermocouple is pressed against the position of the first end of the cavity channel 210, so as to achieve accurate measurement of the real-time temperature of the manufacturing end through the measuring end of the thermocouple being as close as possible to the manufacturing end of the manufacturing portion 200; Optionally, the thermocouple includes two setups, one of which is, as shown, the first end of the thermocouple is connected to the control device 300 (as mentioned above), and the second end of the thermocouple passes through the interior of the transition spindle 100 and then enters the vertical section 212 and is close to the manufacturing end of the manufacturing portion 200; a channel is opened in the interior of the transition spindle 100 to communicate with the cavity channel 210, and then the thermocouple successively passes through the channel in the interior of the transition spindle 100 and the cavity channel 210 in the interior of the manufacturing portion 200, and the thermocouple is arranged in a more stable and reliable manner, and is not easy to make the thermocouple shift, and it can also minimize the interference of external factors on the thermocouple. Second, as shown in the figure, the first end of the thermocouple is still connected to the control device 300, and the second end of the thermocouple is set along the outer wall of the transition spindle 100 and enters from the inclined section 211 to be close to the manufacturing end of the manufacturing portion 200. The thermocouple and the transition spindle 100, the thermocouple and the manufacturing portion 200 can be fixed by the connection of straps and/or buckles. The method of designing the thermocouple on the outside of the transition spindle 100 does not require a hole to be made in the transition spindle 100, and therefore reduces the overall cost.

The connection relationship of the strain measurement assembly 900 and the process of using it together are described in detail as follows: The strain measurement assembly 900 is used to measure the downward force and/or torque of the drive spindle; By detecting the deformation of the extended transition spindle 100 and thereby monitoring the force and torque in the solid-state manufacturing in real time, so as to adjust the solid-state manufacturing parameters by the data obtained, and to achieve the optimization of the indexes at the manufacturing position and the extend the lifespan of the solid-state manufacturing tool.

Optionally, as shown in FIG.5, when there are a plurality of sets of the strain gauges, at least one set is used to measure the drive spindle downward force and at least one set is used to measure the torque of the drive spindle; the strain gauges are selected to be half-bridge strain gauges or full-bridge strain gauges; and in order to ensure that the weight on the transition spindle 100 is uniformly distributed, the strain gauges are uniformly distributed on the outside of the transition spindle 100; Optionally, the strain measurement assembly 900 may also be used in a manner that the force sensor and/or the torque sensor are set up on the outside of the transition spindle 100.

As shown in FIG. 9, the transition spindle 100 is axially divided into multiple sections including a deformation detection region 120 and a support region 110 located on both sides of the deformation detection region 120, the support region 110 is used for installing the protection sleeve 310, and the deformation detection region 120 is used for installing the strain measurement assembly 900; A cavity is formed between the protection sleeve 310 and the transition spindle 100, and the outside of the deformation detection region 120 is provided with a mounting groove in the protection sleeve 310, in which an integrated circuit board assembly 320 is mounted, and a power supply assembly 330 is mounted in the cavity or the mounting groove, and the power supply assembly 330 and the strain measurement assembly 900 are connected to the integrated circuit board assembly 320, and the integrated circuit board assembly 320 is supplied with power by the power supply assembly 330. The integrated circuit board assembly 320 includes at least a wireless signal acquisition module and a wireless signal transmitter module to send and receive measurement signals of the strain measurement assembly 900. The above structural design of the protection sleeve 310 plays a role in that, firstly, the protection sleeve 310 can play a protective role for the strain measurement assembly 900; Secondly, the cavity structural design of the protection sleeve 310 can reduce weight. Thirdly, the cavity can also accommodate the integrated circuit board assembly 320 and the power supply assembly 330. Preferably, the protection sleeve 310 is made of a polymer material, such as nylon, that will not hinder the transmission of wireless signals, and further, the protection sleeve 310 is additively manufactured; Optionally, the protection sleeve 310 is secured to the outside of the transition spindle by a plurality of screws; Similarly, in order to ensure an even weight distribution on the transition spindle 100, the plurality of screws are preferably also uniformly positioned around the circumference of the transition spindle 100.

Optionally, in order to achieve the variation of the control of the force and torque range of the solid-state manufacturing spindle during solid-state manufacturing process of different materials, such as the need for mechanical measurements with smaller ranges and higher accuracy, i.e., the amount of deformation of the transition spindle 100 during solid-state manufacturing process of the joints needs to be larger, the diameter of the deformation detection position (for adhering the position of the strain gauges) can be correspondingly narrowed, and its structure and material can be adjusted accordingly; Specifically, the diameter of the transition spindle 100 in the portion corresponding to the deformation detection region 120 can be made smaller than the diameter of the transition spindle 100 in the portion corresponding to the support region 110; Preferably, the smooth transition between the deformation detection region 120 and the support region 110 ensures the unobstructed transmission of the downward force and torque of the drive spindle to the strain measurement assembly 900 on the deformation detection region 120.

Preferably, a second temperature monitoring assembly 510 is provided at the deformation detection region 120, the second temperature monitoring assembly 510 is positioned in the cavity, it can be a temperature measurement element such as a thermocouple or an RTD, for example, one end of the thermocouple is connected to the integrated circuit board assembly 320, and the other end of the thermocouple is used for real-time measurement of the temperature of the deformation detection region 120.

Optionally, the support position of the support region 110 may be provided with an accessory such as a rubber ring that increases friction to prevent the protection sleeve 310 from experiencing axial slippage along the transition spindle 100.

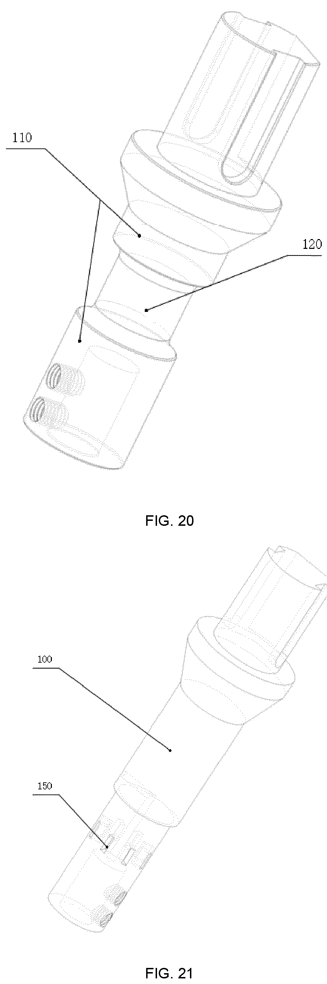

As shown in FIG. 20, the transition spindle 100 may include not only the support region 110 and the deformation detection region 120 as described above, but also a cooling section; Preferably, the cooling section is located on the side of the protection sleeve 310 toward the manufacturing portion 200, so as to prevent excessive heat from being transmitted from the manufacturing portion 200 to the integrated circuit board assembly 320 and the power supply assembly 330; a cooling device 400 is provided on the outside of the cooling section to provide a cooler to the cooling section. The cooling device 400 is provided on the outside of the cooling section to rapidly cool the heat conducted to the cooling section to effectively protect the integrated circuit board assembly 320 and the power supply assembly 330 from damage; Preferably, the cooling section is provided with a cooling groove 150 on the outside of the cooling section.

In practical application, it is found that the heat of the manufacturing portion 200 is still conducted to the deformation detection region 120 on the transition spindle, causing inaccurate monitored data; Therefore, it is preferred that an annular heat-insulating assembly is provided between the deformation detection region 120 of the transition spindle 100 and the manufacturing portion 200; the position of the annular heat-insulating assembly can be selectively installed according to the structure of the axle shank; the annular heat-insulating assembly also needs to be provided to satisfy the requirement that both the ring-shaped heat-insulating assembly should also be set up so as to not only conduct the downward force of the drive spindle, but also isolate or reduce the heat conducted by the manufacturing portion 200 to the deformation detection region 120. Further, the ring-shaped heat-insulating assembly are made of mica, high-temperature-resistant carbon fiber synthetic stone plate and other high-temperature resistant and force-resistant materials; the shape, size, and number of heat-insulating assemblies can be selected according to the actual requirements.

Preferably, the first end of the transition spindle 100 is connected to the drive spindle, and the second end of the transition spindle 100 is provided with a mounting hole 130 coaxial with the solid-state manufacturing tool, and the solid-state manufacturing tool is inserted into the mounting hole 130 and fixedly connected to the transition spindle 100; Optionally, as shown in FIG. 9, one or more threaded holes 140 are provided in the side wall of the mounting hole 130 to allow threaded members to pass through the threaded holes 140 to secure the solid-state manufacturing tool in the mounting hole 130; this design of inserting a section of the solid-state manufacturing tool into the mounting hole 130 resulting in a larger contact surface between the head of the solid-state manufacturing tool and the inner wall of the mounting hole 130, which is more conducive to securing of the solid-state manufacturing tool. Of course, the transition spindle 100 can also be connected to the solid-state manufacturing tool by other methods, such as a threaded configuration designed on both the transition spindle 100 and the solid-state manufacturing tool. It is understood that the above two methods are only elaborations made to facilitate understanding of the contents of the present application, and do not constitute a limitation thereof.

The same or similar symbols in the accompanying drawings of the present embodiment correspond to the same or similar assemblies; in the description of the present application, it is to be understood that, if there are terms such as "up", "down", "left", "right", etc. indicating orientation or positional relationships based on those shown in the accompanying drawings, it is only for the purpose of facilitating the description of the present application and simplifying the description, and is not intended to indicate or imply that the devices or assemblies referred to must be of a particular orientation, constructed and operated with a particular orientation, and therefore, the terms used in the accompanying drawings to describe the positional relationships are for exemplary purposes only and are not to be construed as a limitation of the present patent, and the specific meanings of the terms may be understood in the light of the specific circumstances for those skilled in the art.

The above shows and describes the basic principle and main features of the present application and the advantages of the present application. Those skilled in the art should understand that the present application is not limited by the above embodiments, and that the above embodiments and the description in the specification are only illustrative of the principles of the present application, and that there will be various changes and improvements to the present application without departing from the spirit and the scope of the present application, and that all of these changes and improvements fall within the scope of the present application claimed for protection. The scope of the claimed protection of the present application is defined by the appended claims and their equivalents.

## Claims

1. A solid-state manufacturing method, **characterized by** comprising:
connecting a solid-state manufacturing tool to a transition spindle (100) for driving through a machine head;
starting the solid-state manufacturing device and moving the solid-state manufacturing tool to process along a predetermined route;
during solid-state manufacturing process, measuring deformation of a deformation detection region (120) on the transition spindle (100) by a strain gauge to monitor force and/or torque of the transition spindle (100);
monitoring the temperature of the solid-state manufacturing tool by a first temperature monitoring assembly (500); and
monitoring the temperature in the deformation detection region (120) by a second temperature monitoring assembly (510).

2. The solid-state manufacturing method according to claim 1, wherein the solid-state manufacturing method is a friction stir welding method or a solid-state additive manufacturing method.

3. The solid-state manufacturing method according to claim 1, wherein during solid-state manufacturing process, measuring deformation of the deformation detection region (120) on the transition spindle (100) by the strain gauge to monitor force and/or torque on the transition spindle (100); monitoring temperature of the solid-state manufacturing tool by the first temperature monitoring assembly (500); and monitoring temperature on the deformation detection region (120) by the second temperature monitoring assembly (510) comprises:
an outside of the transition spindle (100) having a control device (300);
receiving and transmitting wireless signals from the strain gauge, the first temperature monitoring assembly (500), and the second temperature monitoring assembly (510) by the control device (300) during the solid-state manufacturing process.

4. The solid-state manufacturing method according to claim 3, wherein an outside of the transition spindle (100) has a control device (300), and receiving and transmitting wireless signals from the strain gauge, the first temperature monitoring assembly (500), and the second temperature monitoring assembly (510) by the control device (300) during the solid-state manufacturing process comprises:
during the solid-state manufacturing process, receiving and transmitting wireless signals from the strain gauge, the first temperature monitoring assembly (500), and the second temperature monitoring assembly (510) by an integrated circuit board assembly (320) within the control device (300), and displaying corresponding signals on a terminal, and supplying power to the integrated circuit board assembly (320) by the power supply assembly (330) within the control device (300).

5. The solid-state manufacturing method according to claim 1, wherein adhering strain gauges to the deformation detection region (120) on the transition spindle (100) to calibrate the force and/or torque measurements before the start of the solid-state manufacturing process.

6. The solid-state manufacturing method according to claim 5, wherein adhering strain gauges to the deformation detection region (120) on the transition spindle (100) to calibrate the pressure and/or torque measurements before the start of the solid-state manufacturing process comprises:
a method of calibrating the force by placing the transition spindle (100) on a designated mold, with the bottom of the transition spindle (100) fixed, and applying sequentially increasing a force of known magnitude from a top of the transition spindle (100), and the control device (300) receives the force signal and calibrates the displayed force signal accordingly.

7. The solid-state manufacturing method according to claim 5, wherein the step of adhering strain gauges to the deformation detection region (120) on the transition spindle (100) to calibrate the force and/or torque measurements before the start of the solid-state manufacturing process comprises:
a method of calibrating the torque by placing the transition spindle (100) on a designated mold, with the bottom of the transition spindle (100) fixed, and applying and sequentially increasing a torque of known magnitude from a top of the transition spindle (100), and the control device (300) receives the torque signal and calibrates the displayed torque signal accordingly

8. The solid-state manufacturing method according to claim 1, wherein
before the start of the solid-state manufacturing process, a first temperature monitoring assembly (500) extends into an end of the cavity channel (210) inside the solid-state manufacturing tool near the manufacturing end to enable real-time monitoring of the temperature during solid-state manufacturing process via the monitoring end of the first temperature monitoring assembly (500).

9. The solid-state manufacturing method according to claim 8, wherein the first temperature monitoring assembly (500) is inserted into the end of the cavity channel (210) inside the solid-state manufacturing tool near the manufacturing end of the solid-state manufacturing tool before the start of the solid-state manufacturing process, to enable real-time monitoring of the temperature of the manufacturing end of the solid-state manufacturing tool during the solid-state manufacturing process via the monitoring end of the first temperature monitoring assembly (500) comprises:
monitoring the temperature of the manufacturing end of the solid-state manufacturing tool by providing a thermocouple at one of a vertical section (212) and an inclined section (211) of the cavity channel (210) to monitor the temperature of the manufacturing end of the solid-state manufacturing tool, and providing a positioning member (600) at the other of the vertical section (212) and the inclined section (211) of the cavity channel (210) to position the thermocouple.

10. The solid-state manufacturing method according to any one of claims 2-9, wherein during solid-state manufacturing process, the outside of the transition spindle (100) has a cooling device (400), by which heat transferred from the solid-state manufacturing tool to the transition spindle (100) is cooled to avoid excessive temperature of the transition spindle (100).

11. The solid-state manufacturing method according to claim 10, wherein during the solid-state manufacturing process, the outside of the transition spindle (100) has a cooling device (400), which faces a side of the solid-state manufacturing tool and by which heat transferred from the solid-state manufacturing tool to the transition spindle (100) is cooled to avoid excessive temperature of the transition spindle (100) comprises:
the cooling device (400) being a self-cooling assembly (430) fixedly connected to the outside of the transition spindle (100), wherein the self-cooling assembly (430) rotates synchronously with the transition spindle (100) during solid-state manufacturing process; or
a cooling sleeve (410) rotationally connected to the outside of the transition spindle (100), the cooling sleeve (410) having a cooling module inside to cool the transition spindle (100), during solid-state manufacturing process, wherein the transition spindle (100) rotates relative to the cooling sleeve (410) and the cooling sleeve (410) does not rotate.

12. The solid-state manufacturing method according to claim 11, wherein the cooling device (400) is a self-cooling assembly (430) fixedly connected to the outside of the transition spindle (100), and a step of synchronizing the rotation of the self-cooling assembly (430) to follow the transition spindle (100) during the solid-state manufacturing comprises:
the self-cooling assembly (430) being a semiconductor cooling sheet and/or a fan to dissipate heat from the transition spindle (100) by the semiconductor cooling sheet and/or the fan during the solid-state manufacturing process; and the semiconductor cooling sheet and/or the fan being positioned equally on the outside of the transition spindle (100) to maintain a weight balance at various places of the transition spindle (100).

13. The solid-state manufacturing method according to claim 11, wherein the cooling device (400) comprises a cooling sleeve (410) rotationally connected to the outside of the transition spindle (100), the cooling sleeve (410) has a cooling module inside to cool the transition spindle (100), during the solid-state manufacturing process, wherein the transition spindle (100) rotates relative to the cooling sleeve (410), and the cooling sleeve (410) remains stationary comprises:
a cooling cavity (420) is opened in the cooling sleeve (410), and during the solid-state manufacturing process, the cooling efficiency is controlled by controlling the temperature or flow rate of the fluid entering the cooling cavity (420).

14. The solid-state manufacturing method according to any one of claims 1-9, wherein when the second temperature monitoring assembly (510) monitors that the temperature at the deformation detection region (120) is below the minimum value of a preset temperature range, a position is heated by a heating module (700).

15. The solid-state manufacturing method according to claim 10, wherein when the second temperature monitoring assembly (510) monitors that the temperature of the deformation detection region (120) is higher than a maximum of a preset temperature range, the cooling efficiency of the cooling device (400) is increased to reduce the heat conducted from the solid-state manufacturing tool to the transition spindle (100).

16. The solid-state manufacturing method according to any one of claims 2-9, wherein in order to achieve constant temperature control of the deformation detection region (120), before the start of the solid-state manufacturing process, different temperatures are calibrated to obtain the offset value pattern of the strain gauge measurement data at each temperature, to form an error correction curve corresponding to the temperatures and input the error correction curve to the control device (300), and the correct strain gauge measurement data is derived by referring to the curve.

17. The solid-state manufacturing method according to any one of claims 1-9, wherein before the solid-state manufacturing process begins, an annular thermal insulation assembly is installed between the transition spindle (100) and the solid-state manufacturing tool to reduce the conduction of heat generated by the solid-state manufacturing tool to the transition spindle (100) during the manufacturing process.

18. A solid-state manufacturing device, wherein the solid-state manufacturing device implements the method of any one of claims 1-17.
